# EUROPEAN PATENT APPLICATION

(11) **EP 3 037 492 A1**
(43) Date of publication of application: **29.06.2016**
(21) Application number: 15201773.7
(22) Date of filing: 21.12.2015
(51) Int. Cl.: C09D 179/04, C08G 73/06, C08L 61/12, C08G 8/22, C08G 59/40

(54) **LIQUID UNDERFILL MATERIAL COMPOSITION FOR SEALING SEMICONDUCTOR AND FLIP-CHIP SEMICONDUCTOR DEVICE**

(30) Priority: 25.12.2014 JP 2014263000
(71) Applicant: Shin-Etsu Chemical Co., Ltd., Tokyo 100-0004 (JP)
(72) Inventor: KUSHIHARA, Naoyuki, Gunma, 3790224 (JP); SUMITA, Kazuaki, Gunma, 3790224 (JP)
(74) Representative: Peters, Hajo

(57) **Abstract**

Provided is a liquid underfill material composition which has a favorable curing property without adding a curing catalyst; a favorable thin film penetration ability derived from its low viscosity; a favorable adhesiveness; and a high heat resistance property. The liquid underfill material composition for sealing a semiconductor contains specific amounts of:
(A) a cyanate ester resin having at least two cyanate groups in one molecule;
(B) a phenolic curing agent including a resorcinol type phenol resin; and
(C) an inorganic filler including (C-1) an inorganic filler (A) which is a silica having an average particle size of 0.1 to 3 µm; and (C-2) an inorganic filler (B) which comprises an amorphous nanosilica having an average particle size of 5 to 70 nm.

## Description

### [Technical field]

The present invention relates to a liquid underfill material composition for sealing semiconductor and a power device sealed by a cured product of such composition.

### [Background art]

At the present day, by addressing global environmental countermeasure such as a global warming countermeasure and a development of alternative energy resources other than fossil fuels, vehicles such as a hybrid vehicle and an electric vehicle have become popular. And the number of home electrical appliances equipped with inverter motor drives has increased due to an energy-saving solution in developing countries such as China, India and so on. In the fields of hybrid vehicle, electric vehicle, and inverter motor drive, it is important to use a power semiconductor device which converts DC into AC or vice versa, or transforms a voltage. However, silicon (Si) used as a semiconductor for a long time is about to reach a performance limitation, thereby making it difficult to expect a dramatic performance improvement. Next-generation power semiconductor devices have therefore gained a lot of attention, and these devices usually employ materials such as silicon carbide (SiC), gallium nitride (GaN) and diamond. For example, although a low-value resistance of a power MOSFET (Metal-Oxide-Semiconductor Field-Effect Transistor) is required in order to reduce power loss when electric power is converted, it is difficult to considerably lower the resistance through a current mainstream Si-MOSFET. Accordingly, there has been developed a low-loss power MOSFET using SiC which is a semiconductor having a wide band gap. SiC and GaN have advantageous properties such that their band gaps are approximately three times larger than Si, and their insulation breakdown field strengths are more than ten times larger than Si. Further, SiC and GaN have other advantageous properties such as high operating temperatures (a report exists about SiC operating at 650°C), high thermal conductivities (SiC and Cu are almost equally conductive), and high saturation electron drift velocity. Due to the properties described above, it is possible to decrease an on-resistance of a power semiconductor device and dramatically reduce the power loss of a power converter circuit, by using SiC and/or GaN.

Currently, although a power semiconductor device is generally protected through, for example, transfer molding using an epoxy resin and potting sealing using a silicone gel, transfer molding using an epoxy resin is about to become a mainstream in view of reduction in the size and weight of a power semiconductor (particularly, in an automobile field). Further, as for a package structure, a report exists about an IGBT (Insulated Gate Bipolar Transistor) having a flip-chip structure in view of reduction in thickness and improvement in radiation performance.

Such seal material, especially an epoxy resin used as an underfill material is a heat-curable resin exhibiting an excellent moldability, injection performance, adhesion with base material, and mechanical strength, thereby being a well-balanced material. However, a thermodecomposition at a cross-linked point in the epoxy resin progresses under a temperature higher than 200°C, thus raising a concern that SiC and GaN may probably not be able to function as sealing materials in a high-temperature operating environment as expected initially,

A cyanic acid ester compound has been studied as a thermosetting resin composition which delivers a superior heat resistance as compared to an epoxy resin. While a cured product of a cyanic acid ester compound has a heat resistance of over 200°C, a heat curing reaction does not progress (trimerization reaction) under a low temperature (see, references 1 to 3, for example), thus making it necessary in general to mix in a curing-accelerating catalyst.

When adding a catalyst in order to enhance a curing speed of a cyanic acid ester compound, the catalyst is generally solved into a solvent to produce a solution, followed by mixing the solution with the cyanic acid ester compound for uniform dispersion of the catalyst in the resin. However, according to such method, while curing the cyanic acid ester compound, the solvent is volatilized, and thus there occurs a problem where either the cured product has defects, or a long-term heat resistance property of the cured product is impaired due to an insufficient heat resistance of components of the solvent. Further, the cured product is not reliable enough to be used as a high-voltage insulating material because an organic metal compound, mainly used as a catalyst, causes a voltage resistance of the cured product to decrease.

### [Prior art documents]

### [Patent documents]

[Patent document 1] JP-A-2010-254838 8
[Patent document 2] JP-A-2003-332701
[Patent document 3] JP-A-2003-002949

### [Summary of the invention]

### [Problem to be solved by the invention]

The first object of the present invention is to provide a liquid underfill material composition which has a favorable curing property without adding a curing catalyst; a favorable thin film penetration ability derived from its low viscosity; a favorable adhesiveness; and a high heat resistance property. The second object of the present invention is to provide a power device having a high reliability by using such underfill material composition.

### [Means to solve the problem]

As a result of extensive studies for attaining the above objects, the inventors of the present invention found that it was possible to attain the objects by a liquid underfill material composition for sealing semiconductor, containing a cyanate ester resin having at least two cyanate groups in a molecule; a phenol curing agent including a resorcinol type phenol resin; and a specific inorganic filler, thereby achieving the present invention. That is to say, the present invention provides the following liquid underfill material composition for sealing semiconductor and flip-chip semiconductor device.
[1] A liquid underfill material composition for sealing a semiconductor, having:
   (A) a cyanate ester resin having at least two cyanate groups in one molecule;
   (B) a resorcinol type phenol resin represented by the following general formula (1): 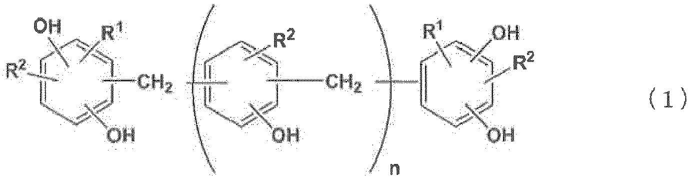 (In the general formula (1), n represents an integer from 0 to 10, each of R¹ and R² represents a hydrogen atom or a monovalent group selected from an alkyl group, an aryl group, an allyl group, and a vinyl group each having 1 to 10 carbon atoms.); and
   (C) an inorganic filler being in an amount of 40 to 80% by mass with respect to the entire composition and including:
      (C-1) an inorganic filler (A) which is a silica having an average particle size of 0.1 to 3 µm; and
      (C-2) an inorganic filler (B) which comprises an amorphous nanosilica having an average particle size of 5 to 70 nm and having its surface treated with a silane coupling agent represented by the following general formulae (2) and/or (3):

         (Cₙ^{H}₂ₙ₊₁O)₃Si-C₆H₅ (2)

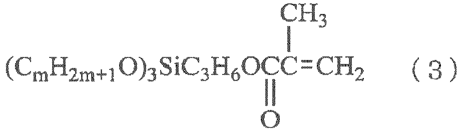

         (In the general formulae (2) and (3), n represents an integer from 1 to 5, and m represents 1 or 2.), the inorganic filler (B) being surface treated with 3 to 20 parts by mass of the silane coupling agent with respect to 100 parts by mass of the amorphous nanosilica. Here, a content of the inorganic filler (B) is 0.5 to 10% by mass with respect to the entire component (C).
[2] A liquid underfill material composition for sealing a semiconductor according to [1], further having (D) a curing accelerator.
[3] A liquid underfill material composition for sealing a semiconductor according to [1] or [2], further having (E) a liquid epoxy resin; the liquid epoxy resin is an epoxy resin or a combination of two or more epoxy resins which are selected from the group consisting of a bisphenol A epoxy resin, a bisphenol F epoxy resin, a naphthalene epoxy resin and an epoxy resin represented by the following general formula (4): 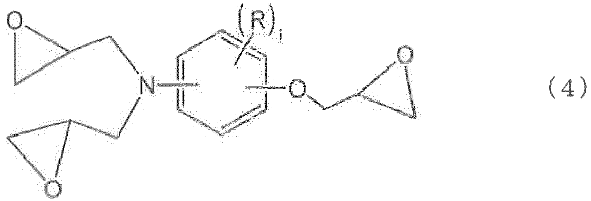 (In the general formula (4), R is selected from a hydrogen atom, a halogen atom, an unsubstituted or substituted monovalent hydrocarbon group having 1 to 6 carbon atoms, an alkoxy group having 1 to 6 carbon atoms, and aryl group having 6 to 12 carbon atoms, Rs may be identical to or different from one another, and i represents an integer from 0 to 3.); the liquid epoxy resin exhibits a viscosity of 0.1 to 1,000 Pa·s at 25°C when measured by an E type viscometer based on a method according to JIS K7117-2: 1999; and the liquid epoxy resin is contained in an amount of 10 to 50 parts by mass with respect to 100 parts by mass of a sum total of the components (A), (B) and (D).
[4] A liquid underfill material composition for sealing a semiconductor according to any one of [1] to [3], wherein the cyanate ester resin of the component (A) is in a liquid form at 80°C.
[5] A flip-chip semiconductor device sealed by the liquid underfill material composition for sealing a semiconductor according to any one of [1] to [4].

### [Effects of the invention]

The present invention is capable of providing a liquid underfill material composition for sealing a semiconductor which exhibits a high glass-transition temperature (Tg), high adhesiveness, high heat resistance property (weight-loss temperature), high thin film penetration ability and low viscosity, without using any curing catalysts.

### [Mode for carrying out the invention]

A detailed description of the present invention is presented below, but the present invention is not limited to the following description.

### (A) Cyanate ester resin

Component (A) is a main component of all components used in the present invention and is a cyanate ester compound having at least two cyanate groups in one molecule.
As such cyanate ester resin of the Component (A), there can be used those known publicly. Examples of such cyanate ester compound include bis(4-cyanatophenyl)methane, bis(3-methyl-4-cyanatophenyl)methane, bis(3-ethyl-4-cyanatophenyl)methane, bis(3,5-dimethyl-4-cyanatophenyl)tnethane, 1,1-bis(4-cyanatophenyl)ethane, 2,2-bis(4-cyanatophenyl)propane, 2,2-bis(4-cyanatophenyl)-1,1,1,3,3,3-hexafluoropropane, di(4-cyanatophenyl)thioether, 1,3-dicyanatobenzene, 1,4-dicyanatobenzene, 2-tert-butyl-1,4-dicyanatobenzene, 2,4-dimethyl-1,3-dicyanatobenzene, 2,5-di-tert-butyl-1,4-dicyanatobenzene, tetramethyl-1,4-dicyanatobenzene, 1,3,5-tricyanatobenzene, 2,2'-dicyanatobiphenyl, 4,4'-dicyanatobiphenyl, 3,3',5,5'-tetramethyl-4,4'-dicyanatobiphenyl, 1,3-dicyanatonaphthalene, 1,4-dicyanatonaphthalene, 1,5-dicyanatonaphthalene, 1,6-dicyanatonaphthalene, 1,8-dicyanatonaphthalene, 2,6-dicyanatonaphthalene, 2,7-dicyanatonaphthalene, 1,3,6-tricyanatonaphthalene, 1,1,1 -tris(4-cyanatophenyl)ethane, bis(4-cyanatophenyl)ether; 4,4'-(1,3-phenylenediisopropylidene)diphenylcyanate, bis(4-cyanatophenyl)thioether, bis(4-cyanatophenyl)sulfone, tris(4-cyanatophenyl)phosphine, phenol novolac type cyanate, cresol novolac type cyanate, and dicyclopentadiene novolac type cyanate. Not only one kind, but two or more kinds of the cyanate ester compounds described above may also be used in combination.

In particular, cyanate ester resins which are in liquid form at 80°C are preferred, and examples of such cyanate ester compound include bis(4-cyanatophenyl)methanc, bis(3-methyl-4-cyanatophenyl)methane, 1,1-bis(4-cyanatophenyl)ethane, and phenol novolac type cyanate ester. 1,1-bis(4-cyanatophenyl)ethane or a phenol novolac type cyanate ester represented by the following general formula (5) is more preferred. 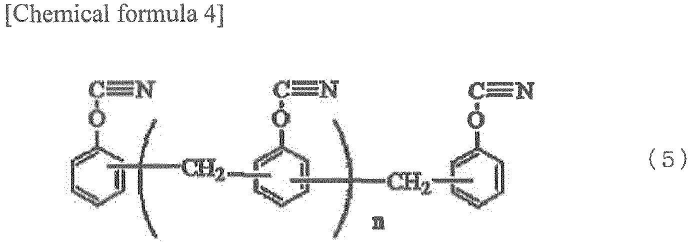 (In the general formula (5), n represents an integer from 0 to 6.)

The cyanate ester resin of the component (A) can be used in an amount of preferably 30 to 98% by mass of a whole amount resin, more preferably 40 to 95% by mass, and particularly preferably 50 to 95% by mass.

### (B) Phenolic curing agent

A phenolic curing agent of the component (B) is a resorcinol type phenol resin represented by the following general formula (1). 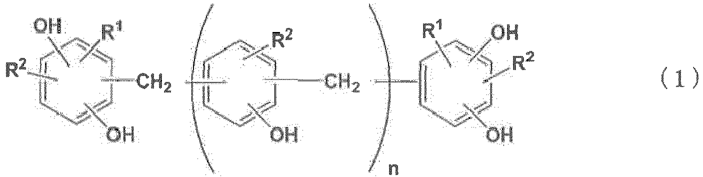 (In the general formula (1), n represents an integer from 0 to 10, each of R¹ and R² represents a hydrogen atom or a monovalent group selected from an alkyl group, an aryl group, an allyl group, and a vinyl group, each group having 1 to 10 carbon atoms.)

It is preferred that n of the above general formula (1) is from 0 to 10 in view of melt liquidity, and more preferably is from 0 to 5. In the case that n is greater than 10, liquidity of such resin composition becomes lower because the resin composition is insoluble at a temperature of not more than 100°C. Two or more kinds of the phenolic curing agent respectively having different values of n may be used in combination, and the phenol curing agents having distributed values of n may also be used.

In the above general formula (1), it is preferred that each of R¹ and R² represents a hydrogen atom or a monovalent group selected from an alkyl group, an aryl group, an allyl group, and a vinyl group, each group having 1 to 10 carbon atoms. Particularly, a hydrogen atom or an allyl group is preferred. Further, R¹ and R² may be functional groups different from each other. When using an aryl group having more than 10 carbon atoms, the melting viscosity (liquidity) of the resin composition becomes lower.

According to the resorcinol type phenol resin, the melting resin viscosity can be decreased, and the curing reaction of the cyanate ester can be facilitated. Furthermore, a cured product having an excellent heat resistance can be obtained due to an excellent heat resistance of the resorcinol type phenol resin itself.

The phenol curing agent (B) can be used in the amount where cyanate groups (CN group) in the cyanate ester compound of the component (A) having not less than two cyanate groups (CN group) are in an equivalent amount of preferably 0.5 to 100, more preferably 1 to 50, and particularly preferably 5 to 35 with respect to 1 equivalent amount of a hydroxyl group (OH group) in the resorcinol type phenol resin represented by the general formula (1). When cyanate groups (CN groups) are in an equivalent amount greater than 100, it is not preferable because the resin composition cannot be sufficiently cured, whereas an equivalent amount less than 0.5 is not preferable either because the heat resistance of the cyanate ester itself may be impaired.

### (C) Inorganic filler

An inorganic filler of the component (C) includes an inorganic filler A as a component (C-1) and an inorganic filler B as a component (C-2). The inorganic filler A is a silica having an average particle size of 0.1 to 3 µm, and the inorganic filler B is an amorphous nanosilica having an average particle size of 5 to 70 nm.

The components (C-1) and (C-2) are spherical silicas, and the average particle size of the component (C-1) is measured through laser diffractometry which is convenient and capable of measuring a wide range of particle diameter, whereas the component (C-2) is measured through dynamic light scattering capable of conducting a high precision measurement in a sub-micron scale or smaller.

The component (C-1) needs to be controlled to an average particle size of 0.1 to 3 µm, and preferably 0.3 to 2 µm. When the average particle size is in excess of 3 µm, penetration cross section may be reduced to adversely affect the penetration ability. Further, when the average particle size is in excess of 3 µm, filler precipitation at the time of the penetration and curing may result in the slope of thermal coefficient of expansion between the chip side and the substrate side, which leads to a decrease in a reliability against a thermal shock. On the other hand, average particle size of less than 0.1 µm results in an increased viscosity.

The component (C-1) used may be the one preliminarily surface treated with a coupling agent such as a silane coupling agent or a titanate coupling agent in order to increase binding strength of the components (A) and (B) with the component (C-1). Preferable examples of such coupling agent include silane coupling agents such as epoxy silanes such as γ-glycidoxypropyltrimethoxysilane, γ-glycidoxypropylmethyldiethoxysilane, and β-(3,4-epoxycyclohexyl)ethyltrimethoxysilane; amino silanes such as N-β-(aminoethyl)-γ-aminopropyltrimethoxysilane, γ-aminopropyltriethoxysilane and N-phenyl-γ-aminopropyltrimethoxysilane; and mercapto silanes such as γ-mercaptosilane. The amount and the surface treating method of the coupling agent used for the surface treatment are not particularly limited, and the surface treatment may be accomplished by using a method known in the art,

The component (C-2) employs amorphous nanosilica particles, and the average particle size thereof needs to be controlled to the range of 5 to 50 nm, and preferably 10 to 50 nm. Thin film penetration ability can be further improved by treating the surfaces of the particles having such average particle size, using the silane coupling agent described below, and incorporating such component (C-2) at a particular content with the component (C-1).

Such amorphous nanosilica particles may be synthesized, as described, for example, in JP-B-H-1-55201 by forming chemical flame by a burner in an atmosphere containing oxygen, and introducing metal silicon into the chemical flame to form dust cloud, and to thereby induce explosion.

The component (C-2) is characterized by being surface treated with the silane coupling agent represented by the following general formulae (2) and/or (3).

(CₙH₂ₙ₊₁O)₃Si-C₆H₅ (2)

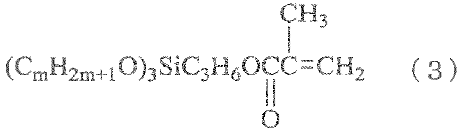

(In the general formulae (2) and (3), n represents an integer from 1 to 5, and m represents 1 or 2.)

An amount of the coupling agent which is used for the surface treatment and represented by the above general formulae (2) and/or (3) is 3 to 20 parts by mass, and more preferably 5 to 15 parts by mass with respect to 100 parts by mass of the component (C-2). When the amount of the silane coupling agent(s) used is smaller than 3 parts by mass, the strength may decrease. Meanwhile, an amount of more than 20 parts by mass may also result in a decrease of the strength.

The amount of the above coupling agent used for the surface treatment and the method used in such surface treatment are not particularly limited, and the surface treatment may be conducted by a method known in the art.

The content of the component (C-2) in the entire component (C) should be controlled to the range of 0.2 to 10% by mass, and more preferably to the range of 0.5 to 7% by mass. And control of the content to the range of 0.2 to 10% by mass leads to decrease in the viscosity of the liquid epoxy resin composition as well as good entry to the narrow gap.

Either of the silane coupling agents represented by the above general formulae (2) and (3), or both of the silane coupling agents represented by the above general formulae (2) and (3) may be used for the surface treatment of the component (C-2), and examples of such silane coupling agent include phenyltrimethoxysilane, phenyltriethoxysilane, phenyltri-n-propoxysilane, 3-methacryloxypropyltrimethoxysilane and 3-methacryloxypropyltriethoxysilane. Particularly, the silane coupling agent represented by the following general formula (3') is preferably used.

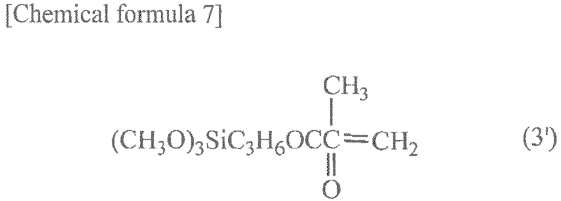

Examples of the commercially available silane coupling agent represented by the above general formulae (2) and (3) include KBM103, KBM503, and KBE503 manufactured by Shin-Etsu Chemical Co., Ltd.

When the component (C-2) is surface treated with a silane coupling agent other than those represented by the above general formulae (2) and (3), for example, an epoxy silane such as γ-glycidoxypropyltrimethoxysilane, γ-glycidoxypropylmethyldiethoxysilane or β-(3,4-epoxycyclohexyl)ethyltrimethoxysilane; an amino silanes such as N-β(aminoethyl)-γ-aminopropyltrimethoxysilane, γ-aminopropyltriethoxysilane or N-phenyl-y-aminopropyltrimethoxysilane; or a mercapto silane such as γ-mercaptosilane, the component (C-2) may, for example, be aggregated, and may not be able to be dispersed in the liquid epoxy resin composition.

The content of such inorganic filler of the component (C) is preferably 40 to 80% by mass and more preferably 60 to 75% by mass of the entire composition. A content of less than 40% by mass results in the high coefficient of expansion, and cracks occurs in the thermal shock test. Meanwhile, a content in excess of 80% by mass results in a high viscosity and a decrease in the thin film penetration ability.

The preferred semiconductor device to be encapsulated with the epoxy resin composition of the present invention is preferably a semiconductor device having a gap size in the range of about 10 µm to about 100 µm, more preferably a flip-chip semiconductor device, and most preferably a flip-chip semiconductor device having a die size greater than 10 mm on a side. In this case, the use of an inorganic filler having an average particle size of up to about one-tenth and a maximum particle size of up to one-half of the flip-chip gap (between the substrate and semiconductor chip) is preferable for realizing both improved penetration ability and lower linear expansion.

If needed, the composition of the present invention may also contain the following additives.

### (D) Curing accelerator

Examples of the curing accelerator of the component (D) include 1,8-diazabicyclo[5.4.0]undecene-7 (DBU), 1,5-diazabicyclo[4.3.0]-nonene-5 (DBN), salts of the DBU and DBN, and amine-based curing accelerators. Specific examples of the salt of the DBU include phenoxide, octylic acid salt, p-toluenesulfonate, formate, orthophthalate, trimellitic ahydride, phenolic novolac resin salt and tetraphenylborate salt of DBU. Further, specific examples of the salt of the DBN include phenoxide, octylic acid salt, p-toluenesulfonate, formate, orthophthalate, trimellitic ahydride, phenolic novolac resin salt and tetraphenylborate salt of DBN. Specific examples of amine-based curing accelerators include an aromatic amine-based curing accelerator such as 3,3'-diethyl-4,4'-diaminodiphenylmethane, 3,3',5,5'-tetramethyl-4,4'-diaminodiphenylmethane, 3,3',5,5'-tetraethyl-4,4'-diarninodiphenylrnethane, 2,4-diaminotoluene, 1,4-phenylenediarnine, 1,3-phenylenediamine, diethyltoluenediamine, 3,4'-diaminodiphenylether, 3,3'-diaminodiphenylmethane, 3,4'-diaminodiphenylmethane, 4,4'-diaminodiphenylmethane, 3,3'-diaminobenzidine, orthotolidine, 3,3'-dimethyl-4,4'-diaminodiphenylmethane, 3,3'-diethyl-4,4'-diaminodiphenylmethane, 2,6-diaminotoluene, and 1,8-diaminonaphthalene; an chain aliphatic polyamine such as N,N'-bis(3-aminopropyl)ethylenediamine, 3,3'-diaminodipropylamine, 1,8-diaminooctane, 1,10-diarninodecane, diethylenetriarnine, triethylenetetramine, and tetraethylenepentamine; and a cycloaliphatic polyamine such as 1,4-bis(3-aminopropyl)piperazine, N-(2-aminoethyl)piperazine, N-(2-aminoethyl)morpholine, N-aminoethyl piperazine and isophoronediamine. Polyamidoamine is produced by the condensation of a dimer acid and a polyamine. Examples of the polyamidoamine include adipic dihydrazide and 7,11-octadecadiene-1,18-dicarbohydrazide. Examples of an imidazole-based curing accelerator include 2-methylimidazole, 2-ethyl-4-methylimidazole, and 1,3-bis(hydrazinocarbonoethyl)-5-isopropylhydantoin. Examples of a guanidine-based curing accelerator include an aliphatic amine such as 1,3-diphenylguanidine and 1,3-di-o-tolylguanidine. Particularly, tertiary amine, tertiary amine salt, or imidazole-based curing accelerator is preferable.

### (E) Liquid epoxy resin

The liquid epoxy resin of the component (E) is an epoxy resin or a combination of two or more epoxy resins which are selected from a group consisting of bisphenol A epoxy resin, bisphenol F epoxy resin, naphthalene epoxy resin and an epoxy resin represented by the following general formula (4).

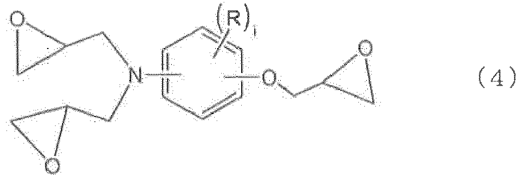

In the general formula (4), R is selected from a hydrogen atom, a halogen atom, an unsubstituted or substituted monovalent hydrocarbon group having 1 to 6 carbon atoms, an alkoxy group having 1 to 3 carbon atoms, and an aryl group having 6 to 12 carbon atoms, preferably 6 to 8 carbon atoms. Specific examples of R include a hydrogen atom; a halogen atom such as fluorine, chlorine and bromine atoms; unsubstituted monovalent hydrocarbon group such as methyl, ethyl, n-propyl, isopropyl, n-butyl, isobutyl and t-butyl groups; these groups where a part or the whole of their hydrogen atoms bonding to carbon atoms are replaced with a halogen atom(s), such as fluorine, bromine and chlorine atoms, or with a cyano group, such as, for instance, halogenated monovalent hydrocarbon group such as trifluoropropyl and chloropropyl groups; a cyanoalkyl group such as β-cyanoethyl and γ-cyanopropyl groups; and a aryl group such as 3-methacryloxypropyl, 3-glycidyloxypropyl, 3-mercaptopropyl, 3-aminopropyl, phenyl, tolyl and naphthyl groups. Among these, particularly, a hydrogen atom and a methyl group are preferred as R. When there are multiple Rs, they may be identical to or different from one another, where i represents an integer from 0 to 3, preferably 0 or 1.

The component (E) is an epoxy resin which is in liquid form at 25°C, and preferably has a viscosity of 0.1 to 1,000 Pa·s, particularly preferably 0.1 to 500 Pa·s when measured by an E type viscometer at 25°C based on a method according to JIS K7117-2: 1999. It is preferable that the viscosity be in these ranges because there can be achieved a low viscosity and a preferred workability.

### Other components

If needed, various additive agents can be mixed into the liquid underfill material of the present invention for sealing semiconductor, and examples of such additive agent include an inorganic filler other than the component (C), a silane coupling agent other than those used for surface treatment of the component (C), a curing agent other than phenol curing agents, a mold release agent, a flame retardant, an ion-trapping agent, an antioxidant, a tackifier, a low stress agent, and a coloring agent.

Examples of the inorganic filler include a silica such as a molten silica, a crystalline silica and a cristobalite which is not described as examples of the component (C); an alumina, a silicon nitride, an aluminum nitride, a boron nitride, a titanium oxide, a glass fiber, and a magnesium oxide. An average diameter or shape of these inorganic fillers can be selected as usage.

The composition of the present invention can be produced by the following method. For example, the cyanate ester compound and the curing agent are mixed while performing heat treatment at the same time or separately when needed, thereby allowing the mixture to be stirred, dissolved, and dispersed, and then the inorganic filler is added into this mixture of the cyanate ester and the curing agent, and the mixture is stirred, dissolved, and dispersed, thus obtaining the mixture of the cyanate ester compound and the curing agent. In this method, mixing, stirring, and dispersing apparatus are not limited, but examples of such apparatus that can be used include a grinding and mixing machine having a stirring device and a heating device, a double roll mill, a triple roll mill, a ball mill, a planetary mixer, and a mass-colloider. These examples may be appropriately used in combination.

### [Examples]

The present invention is described in detail hereunder with reference to working and comparative examples. However, the present invention is not limited to the following working examples.

### Working examples 1 to 8 and comparative examples 1 to 8

Cured products of working examples 1 to 8 and comparative examples 1 to 8 were obtained by mixing the components shown in the Table 2, and heating at 150°C for an hour and at 200°C for four hours. Each component is as follows.

### Component (A): A cyanate resin

### (A-1)1,1-bis(4-cyanatophenyl)ethane

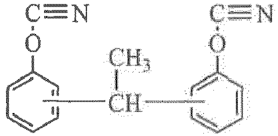

### (A-2) Phenol novolac type cyanate ester (n = 0 to 2) (The trade name is PT30 and it is manufactured by Lonza Ltd.)

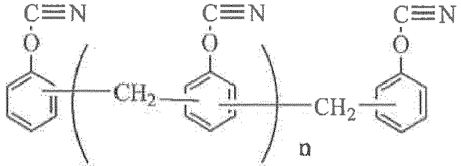

### Component (B): Phenolic curing agent

### Resorcinol type phenol resin

### (B-1) Phenolic curing agent (Compound represented by the following general formula (1) (n = 0 to 4, Each of R¹ and R² represents allyl group)) (The trade name is MEH8400 and it is manufactured by MEIWA PLASTIC INDUSTRIES, Ltd.)

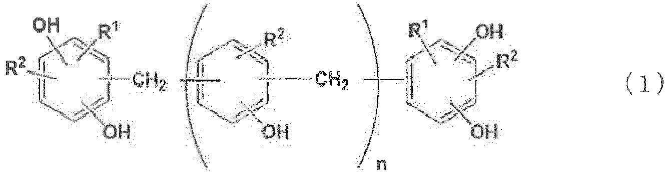

### Aryl type phenol resin

### (B-2) Aryl phenol novolac (The trade name is MEH-8000H and it is manufactured by MEIWA PLASTIC INDUSTRIES, Ltd.)

### (C) Inorganic filler

Spherical silica particles were surface treated as shown in Table 1 to produce various inorganic fillers.

The amount of the silane coupling agent shown in Table 1 is the amount with respect to 100 parts by mass of the spherical silica particles. As the silane coupling agent, there were used KBM573: N-phenyl-3-aminopropyltrimethoxysilane (manufactured by Shin-Etsu Chemical Co., Ltd.), KBM103: phenyltrimethoxysilane (manufactured by Shin-Etsu Chemical Co., Ltd.), and KBM503: 3-methacryloxypropyltrimethoxysilane (manufactured by Shin-Etsu Chemical Co., Ltd.).

**[Table 1]**

| | | |
|---|---|---|
| (C-1) Inorganic filler A | (C-1-1) | Average particle size:0.8µm, surface treated with KBM573(1%) |
| | (C-1-2) | Average particle size:0.3µm, surface treated with KBM573(2%) |
| (C-2) Inorganic filler B Amorphous nonosilica | (C-2-1) | Average particle size:50nm, surface treated with KBM103(5%) |
| | (C-2-2) | Average particle size:10nm, surface treated with KBM103(8%) |
| | (C-2-3) | Average particle size:50nm, surface treated with KBM503(5%) |
| | (C-2-4) | Average particle size:10nm, surface treated with KBM503(8%) |
| | (C-2-5) | Average particle size:50nm, surface treated with KBM573(5%) |
| | (C-2-6) | Average particle size:10nm, surface treated with KBM573(8%) |
| | (C-2-7) | Average particle size:110nm, surface treated with KBM103(5%) |

### (D) Curing accelerator

### (D-1) Tetraphenylborate salt of DBU (U-CAT 5002 manufactured by San-Apro Ltd.)

### (E) Liquid epoxy resin

### (E-1) Bisphenol F epoxy resin: YDF8170 (manufactured by Tohto Kasei Co., Ltd.)

### (E-2) Epoxy resin represented by the following formula (7): jER630LSD (manufactured by Mitsubishi Chemical Corporation)

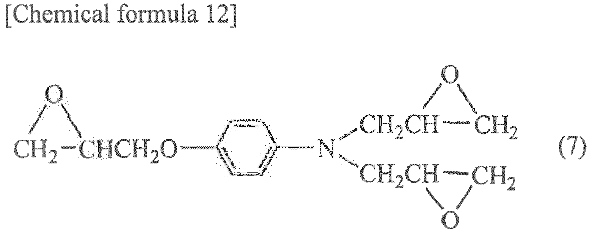

### (F) Curing agent other than phenolic curing agent

### (F-1) 3,3'-diethyl-4,4'-diaminodiphenylmethane (The trade name is Kayahard AA and it is manufactured by Nippon Kayaku Co., Ltd.), Amine equivalent weight is 63.5.

### (F-2) Mixture of an acid anhydride represented by the following general formula (MH700 manufactured by New Japan Chemical co., ltd.)

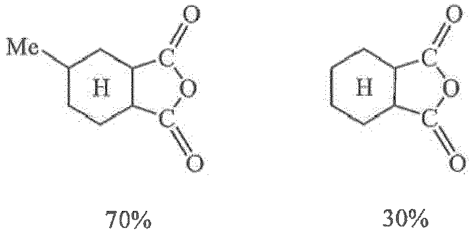

### (G) Silane coupling agent

### (G-1) KBM403: 3-glycidoxypropyltrimethoxysilane (manufactured by Shin-Etsu Chemical Co., Ltd.)

### Viscosity

A viscosity at 25°C was measured by BH-type rotary viscometer at a rotational speed of 4 rpm according to the method described in JIS K7117-2:1999. The results are shown in Table 2.

### Glass transition temperature (Tg)

There were prepared 5x5x15 mm test pieces and Glass transition temperature was determined with a thermal dilatometer (Rigaku TMA8140C) under a load of 19.6 mN at a temperature range from 25°C to 300°C at a rise rate of 5°C/min. The results are shown in Table 2.

### Linear expansion coefficient

An expansion coefficient (CTE1) at a temperature range from 50°C to 80°C was measured. The results are shown in Table 2.

### 5%-weight-loss temperature (Heat resistance test)

A 5%-weight-loss temperature of the cured products in air was measured with a thermogravimetry unit (manufactured by PerkinElmer Japan Co., Ltd., Pyris 1 TGA) at a temperature, range from a room temperature to 550°C at a rise rate of 5°C/min, The results are shown in Table 2.

### Bond strength test

Frustoconical molds made of polytetrafluoroethylene each having a top diameter of 2 mm, a bottom diameter of 5 mm, and a height of 3 mm were filled with the resin compositions respectively, and a copper plate coated with a polyimide (PI) film was placed thereon. After curing the resin at 150°C for one hour and at 200°C for four hours, the mold made of polytetrafluoroethylene was removed, and the resulting test piece was pushed at a constant speed (1 mm/second) to measure shear bond strength. This value was the initial value. Next, the cured test piece was leaved in a tester in which the temperature therein is controlled at 200°C for 500 hours, and then the bond strength was measured in similar manner. In each case, 5 test pieces were measured, and the average value thereof is indicated in Table 2 as the adhesion force. In Table 2, "0" means that the test piece was peeled.

### Void test

There was used a flip-chip semiconductor device having a 10 mm x 10 mm polyimide (PI)-coated silicon chip placed on a 30 mm x 30 mm FR-4 substrate at a gap of about 50 µm, and the resin composition was introduced dropwise into this gap. After curing the resin at 150°C for one hour and at 200°C for four hours, presence of the void was checked by C-SAM (manufactured by SONIX, Inc.). The results are shown in Table 2.
[Table 2]

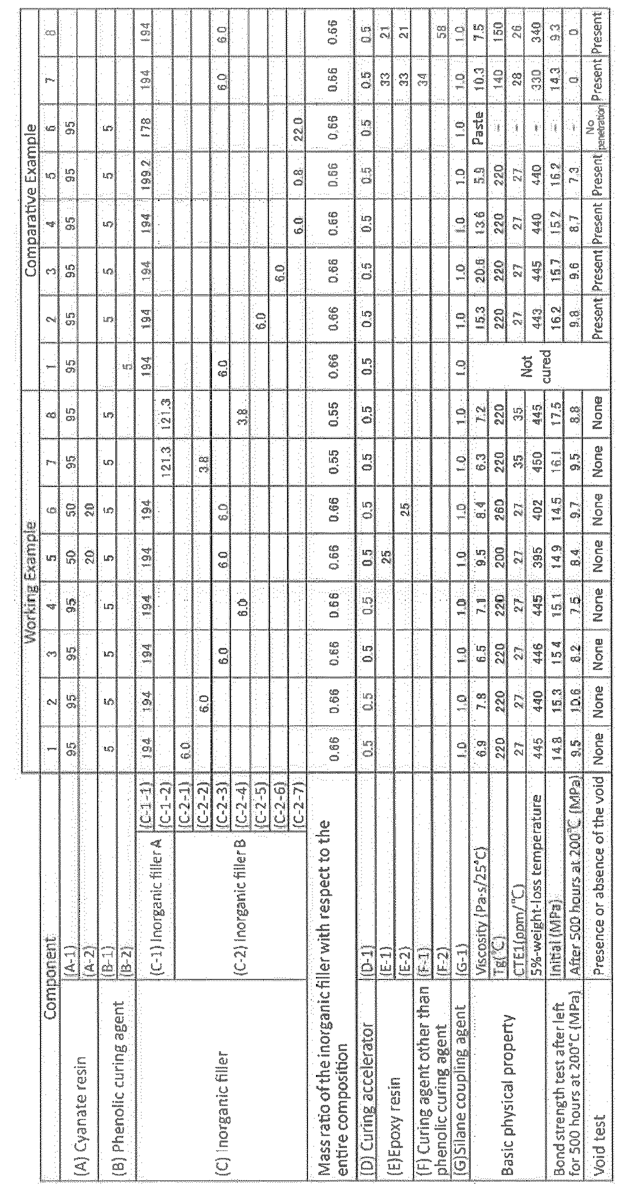

As is clear from the above tables, the cured products of the resin composition of the present invention are the underfill materials having a favorable thin film penetration ability, high glass transition temperature, high weight-loss temperature, and excellent heat resistance property.

## Claims

1. A liquid underfill material composition for sealing a semiconductor, **characterized in that** the composition comprises:
(A) a cyanate ester resin having at least two cyanate groups in one molecule;
(B) a resorcinol type phenol resin represented by the following general formula (1): 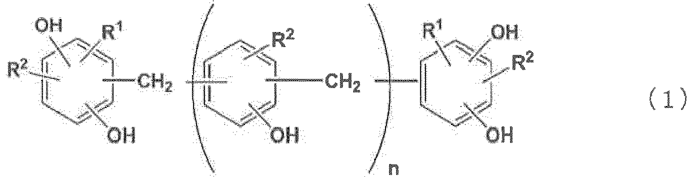 wherein n represents an integer from 0 to 10, and each of R¹ and R² represents a hydrogen atom or a monovalent group selected from an alkyl group, an aryl group, an allyl group, and a vinyl group each having 1 to 10 carbon atoms; and
(C) an inorganic filler being in an amount of 40 to 80% by mass with respect to the entire composition and including:
(C-1) an inorganic filler (A) which is a silica having an average particle size of 0.1 to 3 µm; and
(C-2) an inorganic filler (B) which comprises an amorphous nanosilica having an average particle size of 5 to 70 nm and having its surface treated with a silane coupling agent represented by the following general formulae (2) and/or (3):
(CₙH₂ₙ₊₁O)₃Si-C₆H₅ (2) 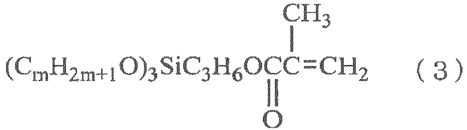
wherein n represents an integer from 1 to 5, and m represents 1 or 2,
the inorganic filler (B) being surface treated with 3 to 20 parts by mass of the silane coupling agent with respect to 100 parts by mass of said amorphous nanosilica and
said inorganic filler (B) being contained in an amount of 0.5 to 10% by mass with respect to the entire component (C).

2. The liquid underfill material composition for sealing a semiconductor according to claim 1, **characterized in that** the composition further comprises (D) a curing accelerator.

3. The liquid underfill material composition for sealing a semiconductor according to claim 1 or 2, **characterized in that** the composition further comprises (E) a liquid epoxy resin including at least one epoxy resin selected from the group consisting of a bisphenol A epoxy resin, a bisphenol F epoxy resin, a naphthalene epoxy resin and an epoxy resin represented by the following general formula (4): 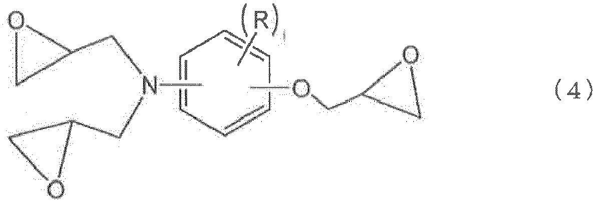 wherein R is selected from a hydrogen atom, a halogen atom, an unsubstituted or substituted monovalent hydrocarbon group having 1 to 6 carbon atoms, an alkoxy group having 1 to 6 carbon atoms, and aryl group having 6 to 12 carbon atoms, Rs may be identical to or different from one another, and i represents an integer from 0 to 3,
said liquid epoxy resin exhibiting a viscosity of 0.1 to 1,000 Pa·s at 25°C when measured by an E type viscometer based on a method according to JIS K7117-2: 1999, and being contained in an amount of 10 to 50 parts by mass with respect to 100 parts by mass of a sum total of said components (A), (B) and (D).

4. The liquid underfill material composition for sealing a semiconductor according to any one of claims 1 to 3, **characterized in that** said cyanate ester resin of said component (A) is in a liquid form at 80°C.

5. A flip-chip semiconductor device sealed by the liquid underfill material composition for sealing a semiconductor according to any one of claims 1 to 4.
